Europäisches Patentamt

European Patent Office

Office européen des brevets

(19)

(11) **EP 0 793 354 B1**

(12) **FASCICULE DE BREVET EUROPEEN**

(45) Date de publication et mention
de la délivrance du brevet:
**16.04.2003 Bulletin 2003/16**

(51) Int Cl.[7]: **H03M 13/00**

(21) Numéro de dépôt: **97410024.0**

(22) Date de dépôt: **25.02.1997**

(54) **Structure intégrée d'un décodeur convolutif de Viterbi**

Integrierte Struktur eines Viterbi-Faltungsdekoders

Integrated structure of a convolutional Viterbi decoder

(84) Etats contractants désignés:
**DE FR GB IT**

(30) Priorité: **28.02.1996 FR 9602647**

(43) Date de publication de la demande:
**03.09.1997 Bulletin 1997/36**

(73) Titulaire: **STMicroelectronics S.A.**
**92120 Montrouge (FR)**

(72) Inventeurs:
• **Michel, Thierry**
**38190 Brignoud (FR)**
• **Remond, François**
**38720 Saint Hilaire du Touvet (FR)**

(74) Mandataire: **de Beaumont, Michel**
**1bis, rue Champollion**
**38000 Grenoble (FR)**

(56) Documents cités:
**US-A- 5 068 859**          **US-A- 5 134 690**
**US-A- 5 491 705**

• **IEEE JOURNAL OF SOLID-STATE CIRCUITS,**
**vol. 26, no. 2, Février 1991, NEW YORK US, pages**
**90-97, XP000203300 SPARSO ET AL: "An**
**area-efficient topology for VLSI implementation**
**of Viterbi decoders and other shuffle-exchange**
**type structures"**
• **IEEE JOURNAL OF SOLID-STATE CIRCUITS,**
**DEC. 1992, USA, vol. 27, no. 12, ISSN 0018-9200,**
**pages 1877-1885, XP002018697 BLACK P J ET**
**AL: "A 140-Mb/s, 32-state, radix-4 Viterbi**
**decoder"**
• **GLOBECOM '90: IEEE GLOBAL**
**TELECOMMUNICATIONS CONFERENCE AND**
**EXHIBITION. 'COMMUNICATIONS:**
**CONNECTING THE FUTURE' (CAT.**
**NO.90CH2827-4), SAN DIEGO, CA, USA, 2-5 DEC.**
**1990, ISBN 0-87942-632-2, 1990, NEW YORK, NY,**
**USA, IEEE, USA, pages 1787-1793 vol.3,**
**XP002018698 SHUNG C B ET AL: "Area-efficient**
**architectures for the Viterbi algorithm"**
• **GLOBECOM '90: IEEE GLOBAL**
**TELECOMMUNICATIONS CONFERENCE AND**
**EXHIBITION. 'COMMUNICATIONS:**
**CONNECTING THE FUTURE' (CAT.**
**NO.90CH2827-4), SAN DIEGO, CA, USA, 2-5 DEC.**
**1990, ISBN 0-87942-632-2, 1990, NEW YORK, NY,**
**USA, IEEE, USA, pages 1323-1327 vol.2,**
**XP002018699 MEIER S R: "A Viterbi decoder**
**architecture based on parallel processing**
**elements"**

EP 0 793 354 B1

**Description**

La présente invention concerne une structure de circuit intégré de décodeur convolutif de Viterbi, et plus particulièrement la structure intégrée des modules d'addition-comparaison-sélection du décodeur.

Le codage et le décodage convolutifs sont utilisés pour diminuer les erreurs dans les transmissions de signaux numériques. Dans un décodeur convolutif de Viterbi, un module d'addition-comparaison-sélection (ACS) est associé à chaque noeud de ce que l'on appelle un treillis. Chaque noeud du treillis correspond à un état possible d'un registre à décalage utilisé dans le codage convolutif.

Etant donné que l'invention ne concerne que la structure d'interconnexion des modules ACS, il est inutile de rappeler le fonctionnement d'un décodeur convolutif de Viterbi, qui est bien connu de la technique. On ne décrit ci-après que les éléments nécessaires à comprendre l'invention.

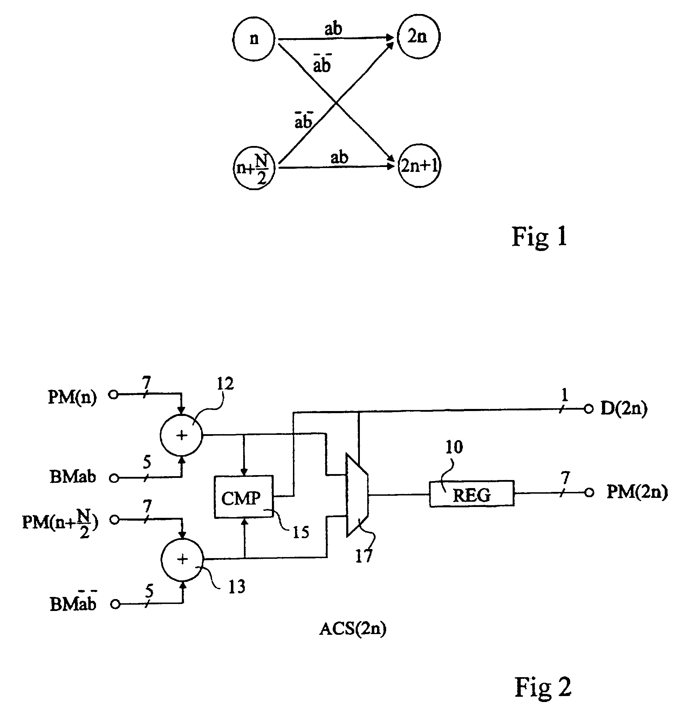

La figure 1 illustre un treillis générique servant à construire tout treillis à N états. Un état 2n et un état 2n+1 sont tous deux reliés à un état n et à un état n+N/2. Le nombre n est un entier positif quelconque et les nombres 2n et 2n+1 sont définis modulo-N. Les liaisons entre états correspondent à des transitions déterminées par des symboles reçus par le décodeur. Dans cet exemple, chaque symbole contient deux bits d'information. Les transitions de l'état n à l'état 2n et de l'état n+N/2 à l'état 2n+1 correspondent à la réception d'un symbole ab, où $\underline{a}$ est égal à 1 ou 0 et b est égal à 1 ou 0 en fonction de la valeur de 2n. Les transitions de l'état n à l'état 2n+1 et de l'état n+N/2 à l'état 2n correspondent à la réception du symbole $\overline{ab}$.

La figure 2 représente des éléments essentiels du module ACS associé à l'état 2n. Ce module ACS(2n) est destiné à mettre à jour une métrique de chemin associée PM(2n) dans un registre 10 et à fournir une décision D(2n). Chaque métrique de chemin est un nombre de 7 bits, par exemple.

Le module ACS(2n) comprend un additionneur 12 qui reçoit la métrique de chemin PM(n) du module ACS associé à l'état n et une métrique de branchement BMab associée, dans le présent exemple, au symbole ab. Un deuxième additionneur 13 reçoit la métrique de chemin PM(n+N/2) fournie par le module ACS associé à l'état n+N/2 et une métrique de branchement $BM\overline{ab}$ associée, dans le présent exemple, au symbole $\overline{ab}$.

Une métrique de branchement BMx est un nombre de cinq bits, par exemple, qui est d'autant plus faible que la probabilité d'avoir reçu le symbole x correspondant est importante. De même, pour un module ACS donné, plus la valeur d'une métrique de chemin PM(y) est faible, plus il est probable que le symbole reçu soit celui correspondant à la transition de l'état y à l'état associé au module ACS.

La décision D(2n) est fournie par un comparateur 15 recevant les sorties des additionneurs 12 et 13.

Elle commande un multiplexeur 17 afin de sélectionner, parmi les sorties des additionneurs 12 et 13, celle dont la valeur est la plus faible. Ainsi, la décision D(2n) indique le plus probable état précédent parmi les états n et n+N/2. La sortie du multiplexeur 17 est stockée dans le registre 10 en tant que métrique de chemin PM(2n) à utiliser à la réception du symbole suivant.

Le module ACS associé à l'état 2n+1 est similaire à celui de la figure 2, sauf que l'additionneur 12 reçoit la métrique de branchement $BM\overline{ab}$ et l'additionneur 13 reçoit la métrique de branchement BMab.

Dans des décodeurs convolutifs couramment utilisés, le treillis est de taille relativement importante, par exemple de 64 états. Alors, les interconnexions entre modules ACS deviennent complexes et il est nécessaire d'accorder un soin particulier au placement et au routage de ces modules ACS sur un circuit intégré, afin de ne pas occuper une surface considérable et affecter la vitesse de fonctionnement.

Une solution optimisée pour placer et router des modules ACS a été trouvée par Sparso et est décrite dans IEEE Journal of Solid State Circuits, Vol. 26, N° 2, February 1991, pages 90-97, "An Area-Efficient Topology for VLSI Implementation of Viterbi Decoders and Other Shuffle-Exchange Type Structures".

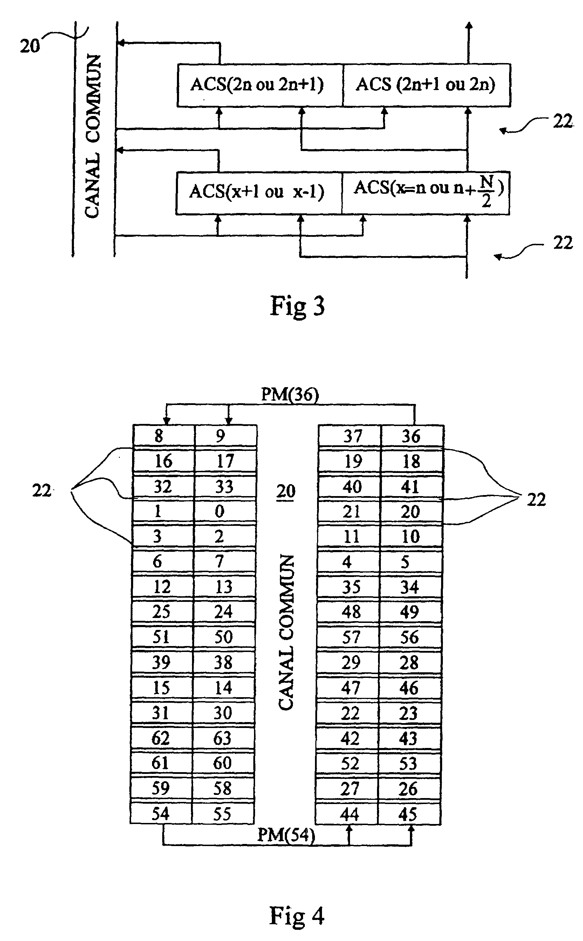

La figure 3 est destinée à illustrer le principe général de placement et routage de Sparso. Les modules ACS sont regroupés par couples en deux colonnes séparées par un canal commun de routage 20. Chaque couple comporte, juxtaposés dans le sens de la largeur de la colonne correspondante, les modules associés aux états 2n et 2n+1 (modulo-N, n étant quelconque). Ces deux modules ACS reçoivent la métrique de chemin PM fournie par le module ACS associé à l'état n ou à l'état n+N/2 qui se trouve, comme cela est représenté, dans un couple rapproché précédent, du côté éloigné du canal commun 20. La métrique de chemin manquante arrive aux modules ACS associés aux états 2n et 2n+1 par l'intermédiaire du canal commun 20.

Il subsiste entre deux couples de modules ACS un canal de routage local 22.

La figure 4 illustre schématiquement une structure de réseau de modules ACS, obtenue en utilisant la méthode de Sparso dans l'exemple d'un treillis à 64 états. Les modules ACS sont illustrés par des cases désignées par les états associés.

La méthode de Sparso est optimale lorsqu'on utilise des technologies d'intégration à deux couches de métallisations. Dans des technologies plus récentes, on dispose de trois couches de métallisations. Si l'on transpose la méthode de Sparso à une technologie à trois couches de métallisations, on ne parvient pas à réduire significativement l'encombrement du réseau de modules ACS par rapport au même réseau réalisé dans une technologie à deux couches de métallisations.

Un objet de la présente invention est de prévoir une structure intégrée optimale d'un réseau de modules ACS dans une technologie à trois couches de métallisations.

Cet objet est atteint grâce à une structure intégrée d'un réseau de N modules d'addition-comparaison-sélection (ACS) associés aux N états d'un treillis d'un décodage convolutif de Viterbi, dans lequel les modules ACS sont physiquement regroupés par couples juxtaposés pour former deux colonnes parallèles séparées, chaque couple comportant deux modules associés respectivement à des états 2n et 2n+1 modulo-N, et dont chacun est relié, pour recevoir deux métriques de chemin, au module associé à l'un des états n et n+N/2 d'un couple rapproché et au module associé à l'autre des états n et n+N/2 d'un couple éloigné, l'espace entre les deux colonnes constituant un canal commun comportant les liaisons entre modules de couples éloignés. La structure est réalisée dans une technologie à trois couches de métallisations et les deux modules ACS de chaque couple sont juxtaposés dans le sens de la hauteur des colonnes.

Selon un mode de réalisation de la présente invention, les modules ACS ont une même topologie et chaque couple a une topologie de métallisations de liaison adaptée à l'une des quatre configurations suivantes :

(0) le module associé à l'état 2n est relié au couple rapproché suivant et au module associé à l'état n du couple rapproché précédent ;
(1) le module associé à l'état 2n+1 est relié au couple rapproché suivant et au module associé à l'état n du couple rapproché précédent ;
(2) le module associé à l'état 2n est relié au couple rapproché suivant et au module associé à l'état n+N/2 du couple rapproché précédent ; et
(3) le module associé à l'état 2n+1 est relié au couple rapproché suivant et au module associé à l'état n+N/2 du couple rapproché précédent.

Selon un mode de réalisation de la présente invention, chaque module ACS d'un couple est relié à deux parmi quatre groupes de lignes de fourniture de métriques de branchement, communes à chaque colonne.

Selon un mode de réalisation de la présente invention, chaque module ACS comporte des premier à troisième groupes de plots pour établir les liaisons avec respectivement le couple rapproché suivant et les modules associés aux états n et n+N/2, et des quatrième et cinquième groupes de plots pour établir des liaisons avec respectivement les deux groupes de lignes correspondants, tous les plots étant disposés selon une topologie commune à tous les modules.

Selon un mode de réalisation de la présente invention, les plots de chaque groupe de plots sont répartis sur la largeur de la colonne correspondante, les plots associés à des bits de poids fort étant du côté éloigné du canal commun, où est intégré un circuit commun aux deux modules du couple correspondant.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 4, précédemment décrites, illustrent l'état de la technique et le problème que vise à résoudre la présente invention ;
la figure 5 illustre schématiquement et à titre d'exemple quatre configurations physiques possibles d'un couple de module ACS selon l'invention, qui constituent des "blocs" d'assemblage pour réaliser un réseau de modules ACS selon l'invention ; et
la figure 6 illustre schématiquement une structure de réseau de modules ACS obtenue selon l'invention dans l'exemple d'un treillis à 64 états.

La présente invention vise à intégrer les modules d'addition-comparaison-sélection (ACS) d'un décodeur convolutif de Viterbi de manière optimale dans une technologie à trois couches de métallisations. Pour cela, l'invention est partiellement basée sur la structure de Sparso (figures 3 et 4). La structure de Sparso est optimale pour des technologies d'intégration à deux couches de métallisations. Toutefois, en transposant cette structure dans une technologie à trois couches de métallisations, il s'avère que l'on ne peut pas réduire significativement la surface occupée. On ne parvient notamment pas à éviter les canaux de routage locaux 22 séparant les couples de modules ACS dans chaque colonne.

Selon l'invention, on utilise des couples de modules ACS déterminés par la méthode de Sparso, mais les modules ACS de chaque couple, au lieu d'être juxtaposés dans le sens de la largeur des colonnes, sont juxtaposés dans le sens de la hauteur. Chaque module ACS est donc distribué sur la largeur de la colonne correspondante. Il en résulte que les connexions entre les modules ACS d'un même couple sont très courtes et verticales. On libére ainsi de la place pour les connexions horizontales et elle sert aux connexions des modules ACS aux métriques de chemin PM du canal commun 20. On parvient pratiquement à supprimer les canaux de routage locaux 22.

La surface occupée par un réseau de modules ACS selon l'invention est environ trois fois inférieure à celle de la structure de Sparso. La diminution de surface présente par ailleurs l'avantage d'entraîner une augmentation de la fréquence limite de fonctionnement.

Le premier module ACS d'un couple selon l'invention, c'est-à-dire le module qui fournit la métrique de chemin PM au couple rapproché suivant, correspond à un module du côté éloigné du canal commun dans la structure de Sparso. Pour simplifier la conception du circuit intégré, les modules ACS ont une même topologie. Pour simplifier la conception davantage, on souhaite pouvoir juxtaposer des éléments de colonne en se souciant le moins possible du routage de ces éléments.

Pour cela, l'invention prévoit quatre configurations de couples de modules ACS qui, en les juxtaposant pour former une colonne, établissent pratiquement toutes les liaisons internes à la colonne. Ainsi, une fois qu'une colonne est formée en choisissant les configurations en fonction des couples à obtenir, il ne reste à router pratiquement que les liaisons externes à la colonne, notamment celles entre couples éloignés qui passent par le canal commun.

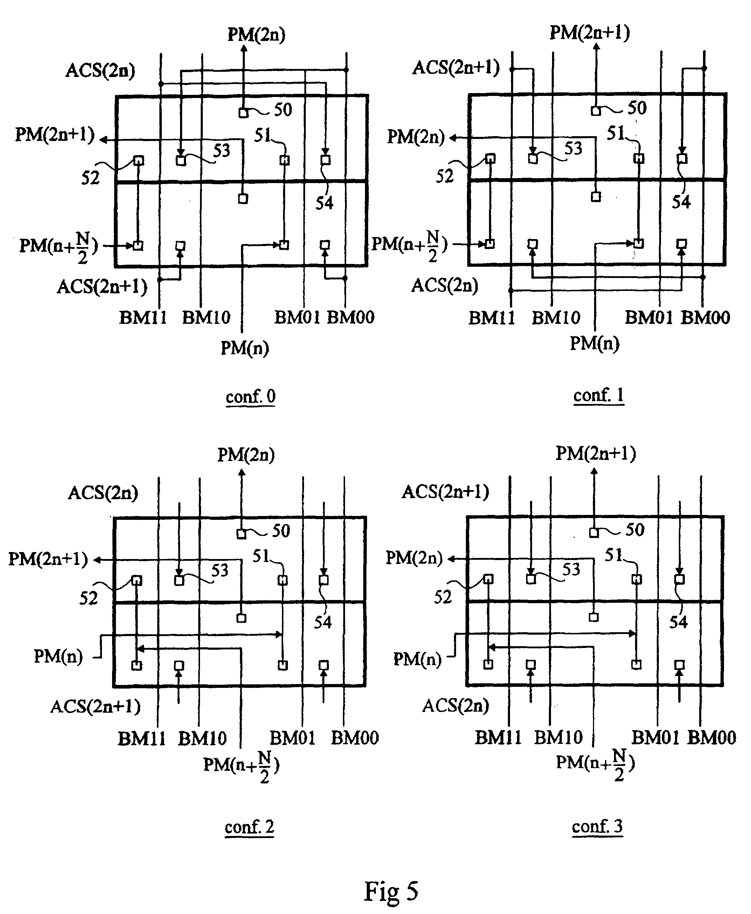

La figure 5 illustre très schématiquement chacune de ces quatre configurations. Chaque module ACS associé à l'état 2n ou 2n+1 du treillis, comporte un plot 50 de fourniture de métrique de chemin PM ; un plot 51 de réception de la métrique de chemin PM(n) provenant du module associé à l'état n ; un plot 52 de réception de la métrique de chemin PM(n+N/2) provenant du module associé à l'état n+N/2 ; et deux plots 53 et 54 pour recevoir respectivement les deux métriques de branchement BM correspondantes parmi les quatre métriques de branchement possibles.

Les quatre métriques de branchement possibles BM00, BM01, BM10, et BM11 sont distribuées à tous les modules d'une colonne par des lignes s'étendant sur la hauteur de la colonne. Les connexions des plots 53 et 54 aux lignes de métriques de branchement s'effectuent par des lignes verticales allant jusqu'à l'extérieur des couples de modules où, dans des canaux de routage locaux réduits, elles rejoignent horizontalement les lignes BM correspondantes. Ceci est représenté pour les configurations 0 et 1 dans lesquelles, à titre d'exemple, les plots 53 et 54 du module ACS(2n) reçoivent respectivement les métriques BM00 et BM11 et les plots 53 et 54 du module ACS(2n+1) reçoivent respectivement les métriques BM11 et BM00.

Chaque métrique de chemin PM ou de branchement BM est un nombre de plusieurs bits auquel on associe, en fait, un groupe de plots qui sont dispersés sur la largeur de la colonne.

La nature des liaisons que l'on doit établir dans les canaux de routage locaux est telle que la surface occupée par ces canaux locaux est négligeable (environ 5 % contre environ 30 % dans l'architecture de Sparso).

Les topologies des modules ACS sont identiques et les attributions internes des plots 50 à 54 ne peuvent être modifiées. Les quatre configurations se distinguent par les métallisations qui relient les plots 50 à 54 à l'extérieur. Les métallisations ne sont représentées que pour les liaisons qui varient d'une configuration à une autre. Bien entendu, les modules comportent d'autres plots, destinés notamment à recevoir des tensions d'alimentation et des signaux de commande et d'horloge. Les métallisations correspondantes, non représentées, sont les mêmes pour les quatre configurations, et elles sont prévues de manière qu'elles se connectent convenablement par la juxtaposition des couples.

Dans une configuration 0, le module ACS associé à l'état 2n est celui qui fournit la métrique de chemin PM(2n) au couple rapproché suivant. Les deux modules du couple reçoivent la métrique PM(n) du couple rapproché précédent. La métrique de chemin PM(2n+1) est fournie au canal commun et la métrique de chemin PM(n+N/2) est reçue par le canal commun.

Dans la configuration 1, les modules ACS sont intervertis par rapport à la configuration 0, c'est-à-dire que c'est le module associé à l'état 2n+1 qui fournit la métrique de chemin PM(2n+1) au couple rapproché suivant. La seule différence avec la configuration 0 réside dans l'affectation externe des plots 50 à 54 qui différencie la manière dont le couple de modules est routé avec l'extérieur, comme cela est représenté pour les connexions aux métriques de branchement BM00 et BM11.

Dans la configuration 2, le module associé à l'état 2n fournit sa métrique de chemin PM(2n) au couple rapproché suivant, et les deux modules reçoivent du couple rapproché précédent la métrique de chemin PM (n+N/2). La métrique de chemin PM(2n+1) est fournie au canal commun et la métrique de chemin PM(n) est reçue par le canal commun.

Dans la configuration 3, les modules ACS sont intervertis par rapport à la configuration 2, c'est-à-dire que le module associé à l'état 2n+1 fournit sa métrique de chemin PM(2n+1) au couple rapproché suivant. La seule différence avec la configuration 2 réside dans l'affectation externe des plots 50 à 54.

La seule différence topologique entre les configurations 0 et 2 et entre les configurations 1 et 3, réside dans l'inversion des liaisons aux plots 51 et 52 recevant les métriques de chemin PM d'un couple rapproché et d'un couple éloigné.

Dans ces quatre configurations, on a représenté des liaisons qui se croisent. Bien entendu, ces liaisons sont réalisées sur deux couches de métallisations.

Une fois que les colonnes ont été formées en juxtaposant les couples, on route en automatique les liaisons qui ne se font pas par la juxtaposition, notamment les liaisons du canal commun 20 et les liaisons aux lignes de métriques de branchement par les canaux locaux réduits.

Un avantage de la présente invention est que certains circuits peuvent, sans contraintes, être mis en commun avec deux modules de chaque couple. C'est le cas notamment d'un circuit de normalisation qui est destiné à contrôler le débordement des registres 10 de métrique de chemin. Ces circuits communs sont situés du côté des bits de poids fort des modules ACS, c'est-à-dire du côté extérieur du circuit, les bits de poids faible étant situés du côté du canal central 20. Ceci minimise la longueur des liaisons entre modules éloignés, et augmente donc la rapidité du circuit.

Dans la structure de Sparso, un circuit de normalisation partagé devrait être placé entre les deux modules d'un couple. Les deux modules seraient alors de topologies symétriques, puisque les bits de poids forts devraient être du côté du circuit de normalisation central. Cette symétrie entraînerait un déséquilibre de longueur entre les lignes de poids faible du côté du canal commun et les lignes de poids faible du côté opposé. Ce déséquilibre entraînerait une diminution de la fréquence de fonctionnement.

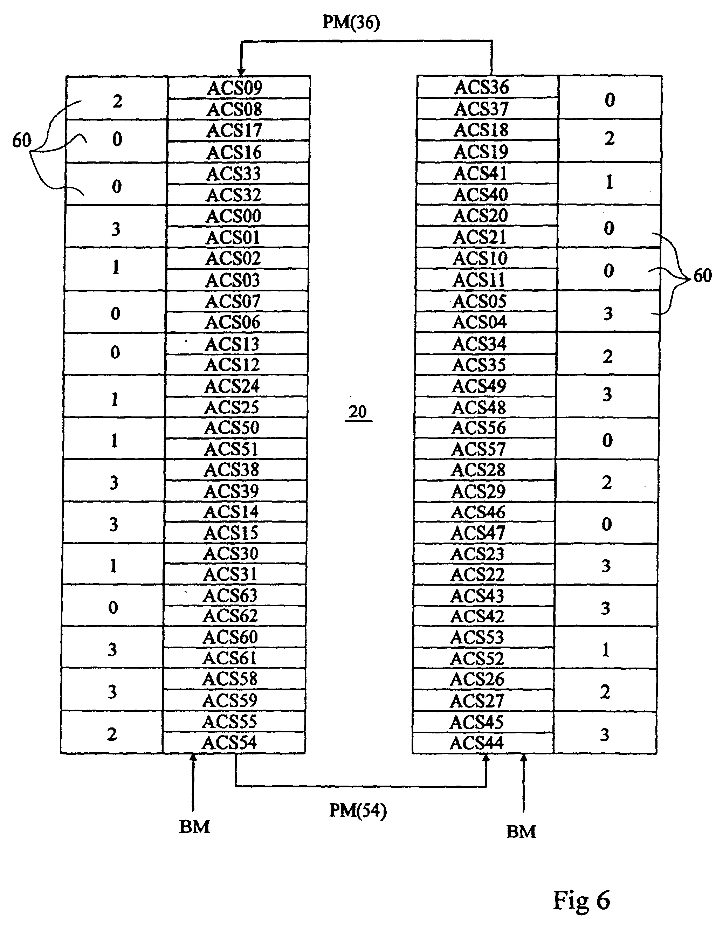

La figure 6 illustre schématiquement une structure intégrée obtenue selon l'invention d'un réseau de modules ACS dans l'exemple d'un treillis à 64 états. Le numéro de la configuration utilisée pour chaque couple est indiqué dans une case 60 à côté de chaque couple, cette case représentant les circuits communs aux deux modules du couple.

## Revendications

1. Structure intégrée d'un réseau de N modules d'addition-comparaison-sélection (ACS) associés aux N états d'un treillis d'un décodage convolutif de Viterbi, dans lequel les modules ACS sont physiquement regroupés par couples juxtaposés pour former deux colonnes parallèles séparées, chaque couple comportant deux modules associés respectivement à des états 2n et 2n+1 modulo-N (n étant un entier positif) , et dont chacun est relié, pour recevoir deux métriques de chemin (PM), au module associé à l'un des états n et n+N/2 d'un couple rapproché et au module associé à l'autre des états n et n+N/2 d'un couple éloigné, l'espace entre les deux colonnes constituant un canal commun (20) comportant les liaisons entre modules de couples éloignés, **caractérisée en ce qu'**elle est réalisée dans une technologie à trois couches de métallisations, et **en ce que** les deux modules ACS de chaque couple sont juxtaposés dans le sens de la hauteur des colonnes.

2. Structure intégrée selon la revendication 1, **caractérisée en ce que** les modules ACS ont une même topologie et chaque couple a une topologie de métallisations de liaison adaptée à l'une des quatre configurations suivantes :

   - (0) le module associé à l'état 2n est relié au couple rapproché suivant et au module associé à l'état n du couple rapproché précédent ;
   - (1) le module associé à l'état 2n+1 est relié au couple rapproché suivant et au module associé à l'état n du couple rapproché précédent ;
   - (2) le module associé à l'état 2n est relié au couple rapproché suivant et au module associé à l'état n+N/2 du couple rapproché précédent ; et
   - (3) le module associé à l'état 2n+1 est relié au couple rapproché suivant et au module associé à l'état n+N/2 du couple rapproché précédent.

3. Structure intégrée selon la revendication 1 ou 2, **caractérisée en ce que** chaque module ACS d'un couple est relié à deux parmi quatre groupes de lignes de fourniture de métriques de branchement (BM), communes à chaque colonne.

4. Structure intégrée selon la revendication 3, **caractérisée en ce que** chaque module ACS comporte des premier à troisième groupes de plots (50-52) pour établir les liaisons avec respectivement le couple rapproché suivant et les modules associés aux états n et n+N/2, et des quatrième et cinquième groupes de plots (53, 54) pour établir des liaisons avec respectivement les deux groupes de lignes (BM) correspondants, tous les plots étant disposés selon une topologie commune à tous les modules.

5. Structure intégrée selon la revendication 4, **caractérisée en ce que** les plots de chaque groupe de plots sont répartis sur la largeur de la colonne correspondante, les plots associés à des bits de poids fort étant du côté éloigné du canal commun (20), où est intégré un circuit (60) commun aux deux modules du couple correspondant.

## Claims

1. An integrated structure of a network of N add-compare-select (ACS) units associated with N states of a trellis of a Viterbi convolutive decoding, wherein the ACS units are physically gathered by pairs juxtaposed to form two spaced apart parallel columns, each pair including two units associated, respectively, with states 2n and 2n+1 modulo-N (n being a positive integer), and each of which is coupled, for receiving two path metrics (PM), to a unit associated with one of states n and n+N/2 of a close pair and to a unit associated with the other of states n and n+N/2 of a remote pair, the space between the two columns constituting a common channel (20) including the interconnections between remote pairs of units, **characterized in that** the structure is implemented in a technology with at least three metallization layers and wherein the two ACS units of each pair are juxtaposed along the column height.

2. An integrated structure according to claim 1, **characterized in that** the ACS units have a same topology and each pair has a connection metallization topology adapted to one of the four following configurations:

   - (0) the unit associated with state 2n is coupled to the next close pair and to the unit associated with state n of the preceding close pair;
   - (1) the unit associated with state 2n+1 is coupled to the next close pair and to the unit associated with state n of the preceding close pair;

- (2) the unit associated with state 2n is coupled to the next close pair and to the unit associated with state n+N/2 of the preceding close pair; and

- (3) the unit associated with state 2n+1 is coupled to the next close pair and to the unit associated with state n+N/2 of the preceding close pair.

3. An integrated structure according to claim 1 or 2, **characterized in.that** each ACS unit of a pair is connected to two out of four groups of branch metric (BM) supply lines, common to each column.

4. An integrated structure according to claim 3, **characterized in that** each ACS unit includes first to third groups of pads (50-52) for establishing the connections with the next close pair and the units associated with states n and n+N/2, respectively, and fourth and fifth groups of pads (53, 54) for establishing connections with the two corresponding groups of lines (BM), respectively, all pads being arranged according to a topology common to all units.

5. An integrated structure according to claim 4, **characterized in that** the pads of each group of pads are distributed along the width of the corresponding column, the pads associated with most significant bits being on the side away from the common channel (20), where circuitry (60) common to the two units of the corresponding pair is integrated.


**Patentansprüche**

1. Integrierte Struktur eines Netzes von N Additions-Vergleichs-Selektions- (ACS)-Modulen in Zuordnung zu N Zuständen eines Gitters einer Viterbi-Faltdekodierung, in welchem die ACS-Module physisch in Paaren nebeneinander regroupiert sind, unter Bildung von zwei parallelen, getrennten Säulen bzw. Spalten, wobei jedes Paar jeweils zwei Module umfasst, die beziehungsweise Zuständen 2n und 2n+1 modulo N zugeordnet sind (wobei n eine positive ganze Zahl ist), und von denen jeweils jeder, zum Empfang von zwei Pfad-Metriken (PM), mit dem Modul, der einem der Zustände n und n+N/2 eines entfernten Paars zugeordnet ist, und mit dem Modul, welcher dem anderen der Zustände n und n+N/2 eines entfernten Paars zugeordnet ist, verbunden ist, wobei der Raum bzw. Abstand zwischen den beiden Spalten bzw. Säulen einen gemeinsamen Kanal (20) bildet, welcher die Verbindungen zwischen Modulen entfernter Paare enthält, **dadurch gekennzeichnet, dass** die Struktur in einer Technologie mit drei Metallisierungsschichten ausgeführt ist und dass die beiden ACS-Module jedes Paars nebeneinander in Richtung der Spaltenhöhe angeordnet sind.

2. Integrierte Struktur nach Anspruch 1, **dadurch gekennzeichnet, dass** die ACS-Module ein und dieselbe Topologie besitzen und dass jedes Paar eine Topologie der Verbindungsmetallisierungen aufweist, die einer der vier folgenden Konfigurationen angepasst ist:

- (0) der dem Zustand 2n zugeordnete Modul ist mit dem folgenden nahen Paar und mit dem Modul verbunden, der dem Zustand n des vorhergehenden nahen Paars zugeordnet ist;

- (1) der dem Zustand 2n+1 zugeordnete Modul ist mit dem folgenden nahen Paar und mit dem Modul verbunden, der dem Zustand n des vorhergehenden nahen Paars zugeordnet ist;

- (2) der dem Zustand 2n zugeordnete Modul ist mit dem folgenden nahen Paar und mit dem Modul verbunden, der dem Zustand n+N/2 des vorhergehenden nahen Paars zugeordnet ist; und

- (3) der dem Zustand 2n+1 zugeordnete Modul ist mit dem folgenden nahen Paar und mit dem Modul verbunden, der dem Zustand n+N/2 des vorhergehenden nahen Paars zugeordnet ist.

3. Integrierte Struktur nach Anspruch 1 oder 2, **dadurch gekennzeichnet, daß** jeweils jeder ACS-Modul eines Paars mit zwei von vier Gruppen von jeweils jeder Spalte gemeinsamen Zeilen zur Zufuhr von Verzweigungsmetriken (BM) verbunden ist.

4. Integrierte Struktur nach Anspruch 3, **dadurch gekennzeichnet, dass** jeweils jeder ACS-Modul erste bis dritte Gruppen von Kontaktkissen bzw. Kontakten (50-52) zur Herstellung der Verbindungen mit dem nächsten benachbarten Paar bzw. mit den den Zuständen n und n+N/2 zugeordneten Modulen aufweist, sowie vierte und fünfte Gruppen von Kontaktkissen bzw. Kontakten (53,54) zur Herstellung von Verbindungen mit den beiden entsprechenden Gruppen von Zeilen (BM), wobei sämtliche Kontakte gemäß einer sämtlichen Modulen gemeinsamen Topologie angeordnet sind.

5. Integrierte Struktur nach Anspruch 4, **dadurch gekennzeichnet, dass** die Kontakte jeder Gruppe von Kontakten über die Breite der entsprechenden Spalte verteilt sind, und dass die Bits hoher Wertigkeit zugeordneten Kontakte auf der von dem gemeinsamen Kanal (20) entfernten Seite liegen, wo eine den beiden Modulen des entsprechenden Paars gemeinsame Schaltung (60) integriert ist.

Fig 1

Fig 2

20

CANAL COMMUN

| ACS(2n ou 2n+1) | ACS (2n+1 ou 2n) |
|---|---|

22

| ACS(x+1 ou x-1) | ACS(x=n ou n+$\frac{N}{2}$) |
|---|---|

22

**Fig 3**

PM(36)

| 8 | 9 | | | 37 | 36 |
|---|---|---|---|---|---|
| 16 | 17 | | | 19 | 18 |
| 32 | 33 | | | 40 | 41 |
| 1 | 0 | | | 21 | 20 |
| 3 | 2 | | | 11 | 10 |
| 6 | 7 | | | 4 | 5 |
| 12 | 13 | | | 35 | 34 |
| 25 | 24 | | | 48 | 49 |
| 51 | 50 | | | 57 | 56 |
| 39 | 38 | | | 29 | 28 |
| 15 | 14 | | | 47 | 46 |
| 31 | 30 | | | 22 | 23 |
| 62 | 63 | | | 42 | 43 |
| 61 | 60 | | | 52 | 53 |
| 59 | 58 | | | 27 | 26 |
| 54 | 55 | | | 44 | 45 |

22

20

CANAL COMMUN

22

PM(54)

**Fig 4**

Fig 5

PM(36)

| | | | |
|---|---|---|---|
| 2 | ACS09 | ACS36 | 0 |
| | ACS08 | ACS37 | |
| 0 | ACS17 | ACS18 | 2 |
| | ACS16 | ACS19 | |
| 0 | ACS33 | ACS41 | 1 |
| | ACS32 | ACS40 | |
| 3 | ACS00 | ACS20 | 0 |
| | ACS01 | ACS21 | |
| 1 | ACS02 | ACS10 | 0 |
| | ACS03 | ACS11 | |
| 0 | ACS07 | ACS05 | 3 |
| | ACS06 | ACS04 | |
| 0 | ACS13 | ACS34 | 2 |
| | ACS12 | ACS35 | |
| 1 | ACS24 | ACS49 | 3 |
| | ACS25 | ACS48 | |
| 1 | ACS50 | ACS56 | 0 |
| | ACS51 | ACS57 | |
| 3 | ACS38 | ACS28 | 2 |
| | ACS39 | ACS29 | |
| 3 | ACS14 | ACS46 | 0 |
| | ACS15 | ACS47 | |
| 1 | ACS30 | ACS23 | 3 |
| | ACS31 | ACS22 | |
| 0 | ACS63 | ACS43 | 3 |
| | ACS62 | ACS42 | |
| 3 | ACS60 | ACS53 | 1 |
| | ACS61 | ACS52 | |
| 3 | ACS58 | ACS26 | 2 |
| | ACS59 | ACS27 | |
| 2 | ACS55 | ACS45 | 3 |
| | ACS54 | ACS44 | |

60

20

60

BM

PM(54)

BM

Fig 6